Europäisches Patentamt

European Patent Office

Office européen des brevets

(19)

(11) Publication number: **0 083 504**
**B1**

(12) **EUROPEAN PATENT SPECIFICATION**

(45) Date of publication of patent specification: **09.09.87**

(21) Application number: **82306983.6**

(22) Date of filing: **30.12.82**

(51) Int. Cl.⁴: **H 03 K 19/003,**
**H 03 K 19/094, H 03 K 17/08**

(54) **MOS type output driver circuit.**

(30) Priority: **29.12.81 JP 213408/81**

(43) Date of publication of application:
**13.07.83 Bulletin 83/28**

(45) Publication of the grant of the patent:
**09.09.87 Bulletin 87/37**

(84) Designated Contracting States:
**DE FR GB**

(56) References cited:
**GB-A-2 005 935**
**US-A-3 447 035**
**US-A-3 749 936**
**US-A-3 938 008**
**US-A-4 275 313**
**US-A-4 329 600**

**Patent Abstracts of Japan, vol. 4, no. 71, 24 May 1980, page 125E12 & JP-A-55-41019**

(73) Proprietor: **FUJITSU LIMITED**
**1015, Kamikodanaka Nakahara-ku**
**Kawasaki-shi Kanagawa 211 (JP)**

(72) Inventor: **Wakimoto, Yasuhiro**
**Eda-house, 101 1673-6, Eda-cho**
**Midori-ku Yokohama-shi Kanagawa 227 (JP)**

(74) Representative: **Fane, Christopher Robin King**
**et al**
**HASELTINE LAKE & CO. Hazlitt House**
**28 Southampton Buildings Chancery Lane**
**London, WC2A 1AT (GB)**

Courier Press, Leamington Spa, England.

# Description

The present invention relates to a metal oxide semiconductor (MOS) type output driver circuit, more particularly, to a protective circuit for protecting an output transistor of the output driver circuit during short-circuits.

N-channel MOS type output driver circuits have recently come into wide use for output driver circuits in address buses and data buses of microcomputers and the like. N-channel MOS type output driver circuits are usually used in bidirectional buses. Therefore, if one output driver circuit erroneously outputs an "H" (high) level when another output driver connected to the same bus line outputs an "L" (low) level, the output transistors of the output driver circuits would be destroyed by overcurrent. This makes it necessary for the output driver circuits to be replaced every time such troubles occur.

Further, quasi-bidirectional bus systems recently have come into general use as address buses and data buses of microcomputor systems. In quasi-bidirectional bus systems, the output driver circuits connected to the bus line are not controlled to the high impedance state, unlike in ordinary bidirectional bus systems. When one of the output driver circuits connected to the same bus line outputs "L", the outputs of the other output drivers, which should be set at "H", must be pulled down to "L" without damage.

An example of a prior art three state bus driver with protection circuitry is disclosed in British Patent Application GB—A—2 005 935.

In this bus driver, a sensing circuit detects occurrence of a short-circuit condition in the output transistor circuit of the driver, and a control circuit connected to the input of each output transistor operates to reduce the gate drive to the conducting one of the output transistors, thereby increasing the impedance of the transistor to limit the output current. A transistor of the control circuit is supplied with a bias voltage from a voltage divider circuit; supply of the bias voltage is delayed by inhibiting means connected to the voltage divider circuit, to prevent the control circuit from operating during transitions between input logic levels.

According to the present invention there is provided a metal oxide semiconductor type output driver circuit having respective high-potential and low-potential power supply lines, first and second transistors connected so that their respective main current flow paths are in series with one another between the two power supply lines, and means for applying first and second mutually-complementary drive signals to the respective gates of the first and second transistors, an output point of said output driver circuit being provided by a series connection point between the two transistors, and said output driver circuit comprising a protective circuit connected between said output point and the gate of the first transistor and operable, in dependence upon the potential at the output point, to increase the impedance of the first transistor if the potential at the output point is lower than a reference voltage when the second transitor is non-conductive, said output driver circuit further comprising a delay circuit arranged and connected to prevent such operation of the protective circuit for predetermined period immediately following an instant at which the second transistor is changed from its conductive to its non-conductive state, said delay circuit receiving at least one of said drive signals, characterised in that

said protective circuit includes a third transistor and a fourth transistor, the source of the third transistor being connected with the output point,

in that said reference voltage has a predetermined reference value and is supplied to the gate of the third transistor,

in that the fourth transistor is connected between the gate of the first transistor and the drain of the third transistor,

in that said delay circuit is connected with the gate of the fourth transistor, so that the protective circuit is operable in dependence upon a signal from the delay circuit as well as upon the potential at the output point,

in that said delay circuit is operable to cause the fourth transistor to be OFF so that the operation of the protective circuit is inhibited for said predetermined period,

and in that said increase of the impedance of the first transistor by said protective circuit is sufficient to switch OFF the first transistor.

An embodiment of the present invention can provide a MOS type output driver circuit which has a protective circuit for the output transistor capable of preventing damage to the output transistor even when the output of the driver circuit is shorted to the ground when "H" is output.

An embodiment of the present invention can provide a MOS type output driver circuit which can be used in a quasi-bidirectional system.

Reference is made, by way of example, to the accompanying drawings in which:

Figure 1 is a circuit diagram of a prior art output driver circuit;

Figure 2 is a circuit diagram of another prior art output driver circuit;

Figure 3 is a basic circuit diagram of a MOS type output driver circuit according to the present invention;

Figure 4 is a circuit diagram of a MOS type output driver circuit in accordance with one embodiment of the present invention,

Figures 5A, 5B and 5C are operational diagrams of the protective operation of the circuit of Fig. 3 in the case of output short-circuits when the "H" level is output;

Fig. 6 is a diagram of waveforms illustrating the protective operation shown in Figs. 5A, 5B, and 5C,

Fig. 7A, 7B, and 7C are operational diagrams of the protective operation of the circuit of Fig. 3 in the case of "H" level output when the output terminal is shorted to the ground; and

Fig. 8 is a diagram of waveforms illustrating the protective operation shown in Figs. 7A, 7B, and 7C.

A MOS type driver circuit according to the present invention will now be described in detail with reference to prior art and preferred embodiment.

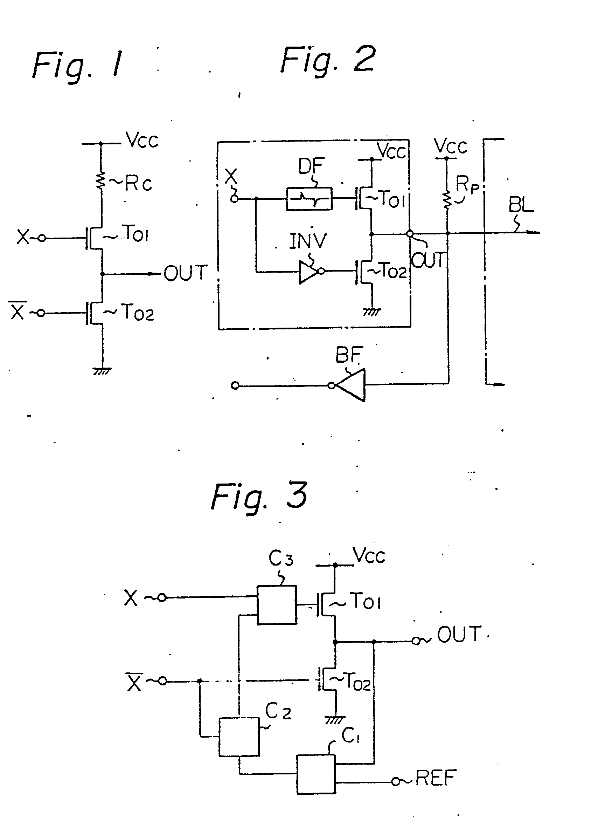

A prior art MOS type output driver circuit is illustrated in Fig. 1. The MOS type output driver circuit of Fig. 1 comprises first and second N-channel MOS type output transistors $T_{01}$ and $T_{02}$ and a current limit resistor $R_C$. One end of the resistor $R_C$ is connected to the voltage supply $V_{cc}$, and the other end is connected to the drain of the first output transistor $T_{01}$. The source of the first output transistor $T_{01}$ is connected to the drain of the second output transistor $T_{02}$, and the source of the second output transistor $T_{02}$ is connected to ground. A first drive signal X is supplied to the gate of the first output transistor $T_{01}$, and a second drive signal $\overline{X}$ inverted with respect to X is supplied to the gate of the second output transistor $T_{02}$. The output signal OUT is led out from the connection point between the first and second output transistor $T_{01}$ and $T_{02}$.

On the output driver circuit of Fig. 1, when the drive signal X is "L" and $\overline{X}$ is "H", the first output transistor $T_{01}$ turns off and the second output transistor $T_{02}$ turns on. Accordingly, the output signal OUT becomes the "L" level. On the other hand, when X is "H" and $\overline{X}$ is "L", the first output transistor $T_{01}$ turns on and the second output transistor $T_{02}$ turns off. Accordingly, the output signal OUT becomes the "H" level.

In the output driver circuit of Fig. 1, even if the output OUT is shorted to the ground when the "H" level is output, the current flowing in the first output transistor $T_{01}$ is limited by the resistor $R_c$. Therefore, the first output transistor $T_{01}$ can be prevented from being damaged by overcurrent. However, the current drive ability of the output driver circuit of Fig. 1 is decreased by the resistor $R_C$. This is quite disadvantageous for an output driver circuit.

Another prior art output driver circuit is illustrated in Fig. 2. The output driver circuit of Fig. 2 comprises first and second N-channel MOS type output transistors $T_{01}$ and $T_{02}$, a differentiation circuit DF, and an inverter circuit INV. The first and second output transistors $T_{01}$ and $T_{02}$ are connected in series between the voltage supply $V_{cc}$ and the ground. The drive signal X is supplied to the inputs of the differentiation circuit DF and the inverter circuit INV. The output of the differentiation circuit DF is supplied to the gate of the first output transistor $T_{01}$, and the output of the inverter circuit INV is supplied to the gate of the second output transistor $T_{02}$. The output signal OUT of the output driver circuit is led out from the connection point between the first and second output transistors $T_{01}$ and $T_{02}$. The output driver circuit of Fig. 2 is mostly used in a quasi-bidirectional bus system as shown in Fig. 2. The output of the output driver circuit is connected to a bus line BL. The input of a buffer circuit BF is also connected to the bus line BL. The bus line BL is connected through a pull-up resistor $R_P$ to the voltage supply $V_{cc}$. In the output driver circuit of Fig. 2, when the drive signal X is the "L" level, the output of the inverter circuit INV is "H". Thus, the second output transistor $T_{02}$ is on, the second output transistor $T_{01}$ is off, and the output level becomes "L". When the drive signal X is changed from the "L" level to the "H" level, the output of the inverter circuit INV becomes "L" and the output transistor $T_{02}$ turns off. On the other hand, the output of the differentiation circut DF becomes "H" level in response to the rising end of the drive signal X, and the first output transistor $T_{01}$ is on only for a short time. Thus, the level of the bus line BL is pulled up to the "H" level by the current flowing through the first output transistor $T_{01}$ while it is on. After that short time, the output of the differentiation circuit DF becomes "L", and the first output transistor $T_{01}$ turns off, thus the level of the bus line BL is kept at "H" only by the pull-up resistor $R_P$. Accordingly, even if the bus line BL is shorted to the ground when the drive signal X is the "H" level, the first output transistor $T_{01}$ is not damaged. Thus, the output driver circuit of Fig. 2 can be used in the quasi-bidirectional bus system. However, the output driver circuit of Fig. 2 is not suitable for use in a usual bidirectional bus system.

The basic circuit of a MOS type output driver circuit according to the present invention is illustrated in Fig. 3. The output driver circuit of Fig. 3 comprises an output circuit having first and second N-channnel MOS type transistors $T_{01}$ and $T_{02}$ connected in series between the voltage supply $V_{cc}$ and the ground, and a protective circuit comprising a detector circuit $C_1$, a delay circuit $C_2$, and a gate circuit $C_3$. A drive signal X is supplied to the gate of the first output transistor $T_{01}$ through the gate circuit $C_3$, and another drive signal $\overline{X}$ inverted with respect to X is supplied to the gate of the second output transistor $T_{02}$. The output signal OUT is led out from the connection point between the first and second output transistors $T_{01}$ and $T_{02}$.

In the output driver circuit of Fig. 3, the level of the output signal OUT is compared with a reference voltage REF in the detector circuit $C_1$ to detect whether the output OUT is lower than the reference voltage REF. The output signal of the detector circuit $C_1$ is supplied to the delay circuit $C_2$. The delay circuit $C_2$ is also supplied with the drive signal $\overline{X}$. When the drive signal $\overline{X}$ is "H" that is the drive signal X is "L", the delay circuit $C_2$ does not operate, and the gate circuit $C_3$ does not inhibit the drive signal X from being supplied to the gate of the first output transistor $T_{01}$. When the drive signal $\overline{X}$ changes from "H" to "L" and the drive signal X changes from "L" to "H", the delay circuit $C_2$ starts to operate after a delay time $T_D$ from the change of the drive signal $\overline{X}$. Thus, the drive signal X is supplied to the gate of the first output transistor $T_{01}$ through the gate circuit $C_3$, the first output transistor $T_{01}$ turns from off to on, and the second output transistor $T_{02}$ turns

from on to off. Accordingly, the level of the output OUT is increased to "H". However, if the output OUT is shorted to the ground, the level of the output OUT is not increased higher than the reference voltage REF in the delay time $T_D$ and the delay circuit $C_2$ outputs a signal to the gate circuit $C_3$ for inhibiting the "H" level signal from being supplied to the gate of the first output transistor $T_{01}$. The first output transistor $T_{01}$ is then turned off and prevented from being damaged by overcurrent.

Assume that the "H" level signal is normally output in the output driver circuit of Fig. 3. Under this condition, if the output OUT is shorted to the ground, then the level of the output OUT falls lower than the reference voltage REF, the detector circuit $C_1$ supplies a signal through the delay circuit $C_2$ to the gate circuit $C_3$, and the first output transistor $T_{01}$ is turned off, thus preventing the first output transistor $T_{01}$ from being damaged by overcurrent.

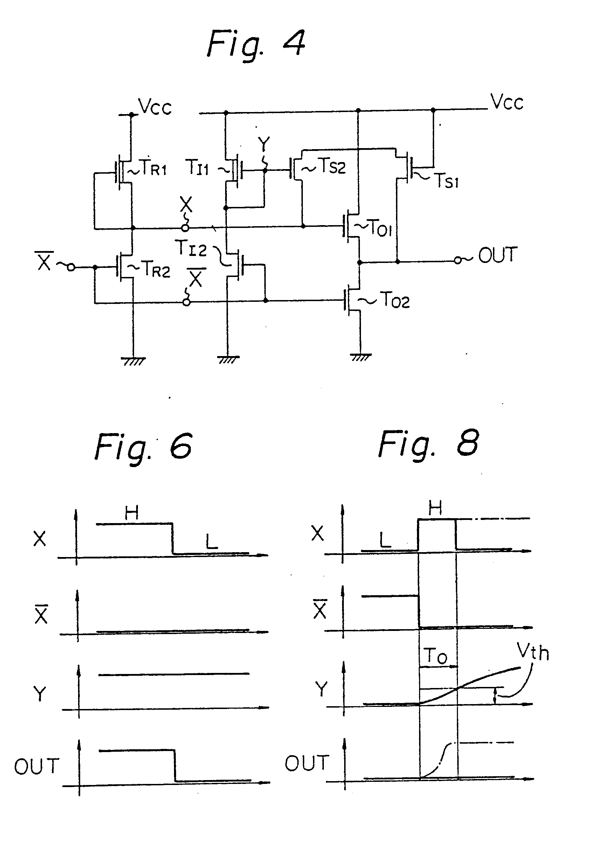

An output driver circuit in accordance with one embodiment of the present invention is illustrated in Fig. 4. The output driver circuit of Fig. 4 comprises an output circuit, having first and second N-channel MOS type output transistors $T_{01}$ and $T_{02}$, and a protective circuit, having N-channel MOS type transistors $T_{S1}$, $T_{S2}$, $T_{I1}$, and $T_{I2}$. The first and second output transistors $T_{01}$ and $T_{02}$ are connected in series between the voltage supply $V_{cc}$ and the ground. A first drive signal X is supplied to the gate of the first output transistor $T_{01}$, and a second drive signal $\overline{X}$ is supplied to the gate of the second output transistor $T_{02}$. The connection point between the first and second output transistors $T_{01}$ and $T_{02}$ is also connected to the output OUT.

In the protective circuit, the source of the transistor $T_{S1}$ is connected to the output OUT of the output circuit, and the gate of the transistor $T_{S1}$ is connected to the voltage supply $V_{cc}$ as the reference voltage.

The drain of the transistor $T_{S1}$ is connected to the source of the transistor $T_{S2}$, and the gate of the transistor $T_{S2}$ is connected to the gate and source of the transistor $T_{I1}$, which is a depletion type transistor. The drain of the transistor $T_{S2}$ is connected to the first drive signal X. The drain of the transistor $T_{I1}$ is connected to the voltage supply $V_{cc}$, and the source of the transistor $T_{I1}$ is connected to the drain of the transistor $T_{I2}$. The gate of the transistor $T_{I2}$ is connected to the second drive signal $\overline{X}$, and the source of the transistor $T_{I2}$ is connected to the ground. Hence TI1, TI2 form an inverter. The first drive signal X may be output by an inverter circuit as shown in Fig. 4. The inverter circuit has N-channel MOS type transistors $T_{R1}$ and $T_{R2}$ connected in series between the voltage supply $V_{cc}$ and the ground.

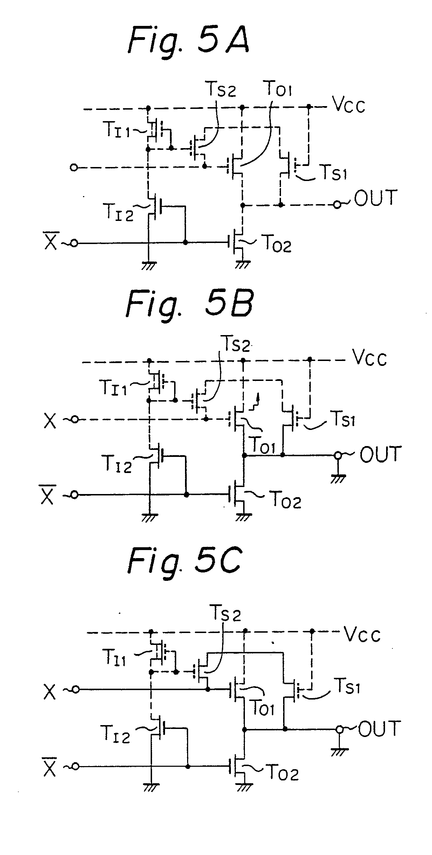

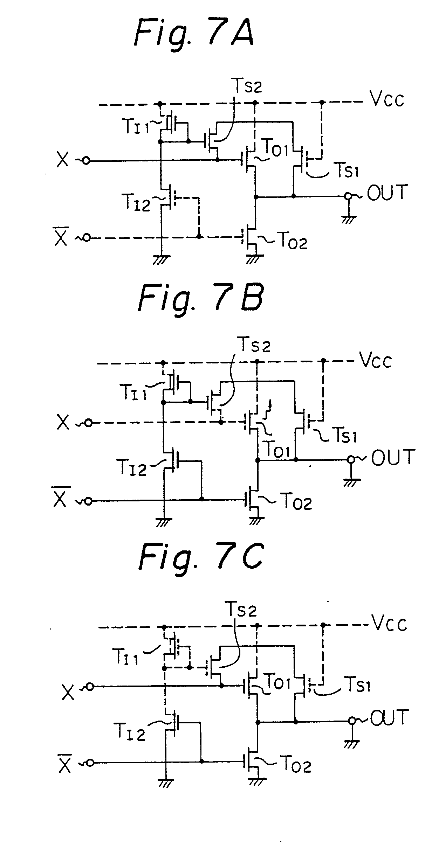

The operation of the protective circuit in the output driver circuit of Fig. 4 in the case where the output OUT is shorted to the ground while the level of the output OUT is "H" is illustrated in Figs. 5A, 5B, and 5C. In these drawings, the broken lines indicate signal lines at the "H" level, and the continuous lines indicate signal lines at the "L" level. Figure 6 illustrates waveforms of various signals in the output driver circuit of Fig. 4 in the above-mentioned case.

First, Fig. 5A illustrates the condition of the output driver circuit in the case where the first drive signal X is "H" and the second drive signal $\overline{X}$ is "L", thus the output OUT is "H". Under this condition, the first output transistor $T_{01}$ is on, the second output transistor $T_{02}$ is off, and the transistor $T_{I2}$ is off. Thus, the level Y of the gate of the transistor $T_{S2}$ is "H", as shown in Fig. 6. Figure 5B illustrates the condition immediately after the output OUT is shorted to the ground under the above-mentioned condition. In the condition of Fig. 5B, the level of the output OUT falls to "L" as shown in Fig. 6 and an overcurrent flows through the first output transistor $T_{01}$ momentarily. Figure 5C illustrates the condition where the protective circuit has operated. In Fig. 5C, since the level of the output OUT falls to "L", the voltage difference between the gate and source of the transistor $T_{S1}$ exceeds the threshold value $V_{th}$, the transistor $T_{S1}$ becomes on. Because the transistor $T_{S2}$ has already turned on, the gate of transistor $T_{01}$ and the output terminal OUT are short-circuited through transistors $T_{S1}$ and $T_{S2}$. Accordingly, the potential of the gate of transistor $T_{01}$ is forced to be pulled down to "L" potential.

The operation of the protective circuit in the output driver circuit of Fig. 4 in the case where the output driver is going to output the "H" level when the output OUT is already shorted to the ground is illustrated in Figs. 7A, 7B, and 7C. In these drawings, the broken lines indicate the signal lines of the "H" level, and the continuous lines indicate the signal lines of the "L" level, the same as in Figs. 5A, 5B and 5C. Figure 8 illustrates various waveforms in the output driver circuit of Fig. 4 in the above-mentioned condition.

First, Fig. 7A illustrates the condition of the output driver circuit in the case where the first drive signal X is "L", the second drive signal $\overline{X}$ is "H", and the output OUT is shorted to the ground. In this condition, the transistor $T_{I2}$ is on, and the level Y of the gate of the transistor $T_{S2}$ is "L".

Figure 7B illustrates the condition immediately after the first drive signal X is changed from "L" to "H" and the second drive signal $\overline{X}$ is changed from "H" to "L" under the condition of Fig. 7A. In this condition, the first output transistor $T_{01}$ turns from off to on and the second output transistor $T_{02}$ turns from on to off. The transistor $T_{I2}$ also turns from on to off, and the level Y of the gate of the transistor $T_{S2}$ starts to be increased by charging the gate capacitor through the on-state resistor of the depletion type transistor $T_{I1}$ as shown in Fig. 8. Since the output OUT is shorted to the ground, the transistor $T_{S1}$ is on, but the transistor $T_{S2}$ is kept off until the gate level Y of the transistor $T_{S2}$ becomes higher than the threshold value $V_{th}$. Figure 7C illustrates the condition where the protective circuit becomes operative. When the gate level Y of the transistor $T_{S2}$ becomes higher than $V_{th}$ after a delay time $T_D$, for example 10 to 20 nanoseconds, the transistor $T_{S2}$ becomes on, the first drive signal X is made to become "L" as shown in Fig. 8, and the first output transistor $T_{01}$ is turned off.

As described above, the protective circuit of the output driver circuit of Fig. 4 does not operate during the delay time $T_D$ after the output is changed to "H". Accordingly, if the output OUT becomes "H" in the delay time $T_D$, the protective circuit does not work, and the output driver circuit of Fig. 4 can output an "H" level signal normally, as shown by one-dotted lines in Fig. 8.

The output driver circuit of Fig. 4 has the following advantages;

1) No necessity of timing signals because of its being asynchronous,

2) Capability of operation even with abnormal capacitive loads,

3) Automatical resetting upon removal of cause of trouble,

4) Simple circuit construction,

5) Ability to be used in quasi-bidirectional bus system without conventional protective function or timing signals,

6) Safety characteristics with regard to temperature increases.

In the above described embodiment, an N-channel MOS type output driver circuit was described. The present invention, however, can be applied to a P-channel MOS type output driver circuit as well.

According to the present invention, there can be provided a MOS type output driver circuit which can be protected from damage by overcurrent owing to short-circuits of the output.

## Claims

1. A metal oxide semiconductor (MOS) type output driver circuit having respective high-potential (Vcc) and low-potential power supply lines, first and second transistors (TO1, TO2) connected so that their respective main current flow paths are in series with one another between the two power supply lines, and means for applying first and second mutually-complementary drive signals (X, X̄) to the respective gates of the first and second transistors, an output point (OUT) of said output driver circuit being provided by a series connection point between the two transistors (TO1, TO2), and said output driver circuit comprising a protective circuit (TS1, TS2) connected between said output point (OUT) and the gate of the first transistor (TO1) and operable, in dependence upon the potential at the output point, to increase the impedance of the first transistor (TO1) if the potential at the output point is lower than a reference voltage when the second transistor (TO2) is non-conductive, said output driver circuit further comprising a delay circuit (TI1, TI2) arranged and connected to prevent such operation of the protective circuit for a predetermined period immediately following an instant at which the second transistor (TO2) is changed from its conductive to its non-conductive state, said delay circuit (TI1, TI2) receiving at least one of said drive signals (X, X̄), characterised in that

said protective circuit includes a third transistor (TS1) and a fourth transistor (TS2), the source of the third transistor (TS1) being connected with the output point (OUT),

in that said reference voltage has a predetermined reference value and in supplied to the gate of the third transistor (TS1),

in that the fourth transistor (TS2) is connected between the gate of the first transistor (TO1) and the drain of the third transistor (TS1),

in that said delay circuit (TI1, TI2) is connected with the gate of the fourth transistor (TS2), so that the protective circuit is operable in dependence upon a signal from the delay circuit as well as upon the potential at the output point,

in that said delay circuit is operable to cause the fourth transistor (TS2) to be OFF so that the operation of the protective circuit is inhibited for said predetermined period,

and in that said increase of the impedance of the first transistor (TO1) by said protective circuit is sufficient to switch OFF the first transistor.

2. An output driver circuit according to claim 1, wherein said delay circuit comprises an inverter.

3. An output driver circuit according to claim 2, wherein said inverter comprises fifth and sixth transistors (TI1, TI2).

4. An output driver circuit according to claim 3, wherein the fifth transistor (TI1) has a drain connected to the high potential (Vcc) power supply line, and a gate and a source both connected to the gate of the fourth transistor (TS2), and the sixth transistor (TI2) has a drain connected to the source of the fifth transistor (TI1), a gate connected to said means for applying first and second mutually complementary drive signals (X, X̄), and a source connected to the low potential power supply line.

5. An output driver circuit according to claim 3 or 4, wherein the gate of the fifth transistor (TI1) and the gate of the third transistor (TS1) are both connected to the source of the fifth transistor (TI1) and to the drain of the sixth transistor (TI2).

6. An output driver according to any preceding claim, wherein the drain of the third transistors (TS1) is connected with the drain of the fourth transistor (TS2).

7. An output driver circuit according to any preceding claim, wherein the gate of said third transistor (TS1) is connected with the high-potential power supply line (Vcc), so as to receive the predetermined reference voltage.

## Patentansprüche

1. Ausgangstreiberschaltung vom Metalloxydhalbleitertyp, mit entsprechenden Hochpotential-(Vcc) und Niedrigpotential- Energieversorgungsleitungen, ersten und zweiten Transistoren (T01, T02), die so angeschlossen sind, daß ihre jeweiligen Hauptstromflußwege in Reihe miteinander zwischen zwei Energieversorgungsleitungen

9 0 083 504 10

liegen, und mit Einrichtungen zur Aufbringung erster und zweiter, gegenseitig komplementärer Treibersignale (X, $\overline{X}$). zu den entsprechenden Gates der ersten und zweiten Transistoren, einem Ausgangspunkt (OUT) der genannten Ausgangstreiberschaltung, der einen Reihenverbindungspunkt zwischen den beiden Transistoren (T01, T02) bildet, und wobei die genannte Ausgangstreiberschaltung eine Schutzschaltung (TS1, TS2) umfaßt, die zwischen dem genannten Ausgangspunkt (OUT) und dem Gate des ersten Transistors (TO1) und in Abhängigkeit von dem Potential bei dem Ausgangspunkt betreibbar ist, um die Impedanz des ersten Transistors (T01) zu erhöhen, wenn das Potential bei dem Ausgangspunkt niedriger als eine Referenzspannung ist, wenn der zweite Transistor (TO2) nichtleitend ist, wobei die genannte Ausgangstreiberschaltung ferner eine Verzögerungsschaltung (TI1, TI2) umfaßt, die angeordnet und angeschlossen ist, um solch einen Betrieb der Schutzschaltung für eine vorbestimmte Periode, die unmittelbar einem Augenblick folgt, bei dem der zweite Transistor (TO2) von seinem leitenden Zustand in seinen nichtleitenden Zustand wechselt, zu verhindern, wobei die genannte Verzögerungsschaltung (TI1, TI2) wenigstens eines der genannten Treibersignale (X, $\overline{X}$), empfängt, dadurch gekennzeichnet, daß

die genannte Schutzschaltung einen dritten Transistor (TS1) und einen vierten Transistor (TS2) umfaßt, die Source des dritten Transistors (TS1) mit dem Ausgangspunkt (OUT) verbunden ist,

daß die genannte Referenzspannung einen vorbestimmten Referenzwert hat und dem Gate des dritten Transistors (TS1) zugeführt wird,

daß der vierte Transistor (TS2) zwischen dem Gate des ersten Transistor (TO1) und dem Drain des dritten Transistors (TS1) angeschlossen ist,

daß die genannte Verzögerungsschaltung (TI1, TI2) mit dem Gate des vierten Transistors (TS2) verbunden ist, so daß die Schutzschaltung sowohl in Abhängigkeit von einem Signal von der Verzögerungsschaltung als auch von dem Potential bei dem Ausgangspunkt betreibbar ist,

daß die genannte Verzögerungsschaltung betreibbar ist, um zu verursachen, daß der vierte Transistor (TS2) AUS ist, so daß der Betrieb der Schutzschaltung für die vorbestimmte Periode gesperrt wird,

und daß der genannte Anstieg der Impedanz des ersten Transistors (TO1) durch die genannte Schutzschaltung ausreicht, um den ersten Transistor auf AUS zu schalten.

2. Ausgangstreiberschaltung nach Anspruch 1, bei der die genannte Verzögerungsschaltung einen Inverter umfaßt.

3. Ausgangstreiberschaltung nach Anspruch 2, bei der der genannte Inverter fünfte und sechste Transistoren (TI1, TI2) umfaßt.

4. Ausgangsteiberschaltung nach Anspruch 3, bei dem der fünfte Transistor (TI1) ein Drain hat, das mit der Hochpotential-Energieversorgungsleitung (Vcc) verbunden ist, und ein Gate und eine Source, die beide mit dem Gate des vierten Transistors (TS2) verbunden sind, und der sechste Transistor (TI2) ein Drain hat, das mit der Source des fünften Transistors (TI1) verbunden ist, ein Gate, das mit der genannten Einrichtung zur Zuführung erster und zweiter wechselseitig komplementärer Treibersignale (X, $\overline{X}$) verbunden ist, und eine Source, die mit der Niedrigpotential-Energieversorgungsleitung verbunden ist.

5. Ausgangstreiberschaltung nach Anspruch 3 oder 4, bei der das Gate des fünften Transistors (TI1) und das Gate des dritten Transistors (TS1) beide mit der Source des fünften Transistors (TI1) und dem Drain des sechsten Transistors (TI2) verbunden sind.

6. Ausgangstreiberschaltung nach einem der vorhergehenden Ansprüche, bei der das Drain des dritten Transistors (TS1) mit dem Drain des vierten Transistors (TS2) verbunden ist.

7. Ausgangstreiberschaltung nach einem der vorhergehenden Ansprüche, bei der das Gate des genannten dritten Transistors (TS1) mit der Hochpotential-Energieversorgungsleitung (Vcc) verbunden ist, um so die vorbestimmte Referenzspannung zu empfangen.

**Revendications**

1. Circuit d'attaque de sortie du type à métaloxyde-semi-conducteur (MOS) comprenant des lignes d'alimentation respectives de potentiel supérieur (Vcc) et de potentiel inférieur, un premier et un second transistor (T01, T02) connectés de manière que leurs circuits principaux de passage de courant soient en série l'un avec l'autre entre les deux lignes d'alimentation et un dispositif destiné à appliquer un premier et un second signal d'attaque mutuellement complémentaires (X, $\overline{X}$) aux grilles respectives du premier et du second transistor, un point de sortie (OUT) dudit circuit d'attaque de sortie étant constitué par un point de connexion en série entre les deux transistors (T01, T02), et ledit circuit d'attaque de sortie comportant un circuit de protection (TS1, TS2) connecté entre ledit point de sortie (OUT) et la grille du premier transistor (T01) et ayant pour fonction, selon le potentiel du point de sortie, d'augmenter l'impédance du premier transistor (T01) si le potentiel au point de sortie est inférieur à une tension de référence quand le second transistor (T02) n'est pas conducteur, ledit circuit d'attaque de sortie comportant en outre un circuit à retard (TI1, TI2) agencé et connecté pour empêcher ce fonctionnement du circuit de protection pendant une période prédéterminée suivant immédiatement un instant auquel le second transistor (T02) passe de son état conducteur à son état non conducteur, ledit circuit à retard (TI1, TI2) recevant l'un au moins desdits signaux d'attaque (X, $\overline{X}$), caractérisé en ce que ledit circuit de protection comporte un troisième transistor (TS1) et un quatrième transistor (TS2), la source du troisième transistor (TS1) étant connecté au point de sortie (OUT), en ce que ladite tension de référence a une valeur de référence prédéterminée et est appliquée à la grille du troisième

6

transistor (TS1), en ce que le quatrième transistor (TS2) est connecté entre la grille du premier transistor (T01) et le drain du troisième transistor (TS1), en ce que ledit circuit à retard (TI1, TI2) est connecté à la grille du quatrième transistor (TS2) de manière que le circuit de protection fonctionne en fonction d'un signal provenant du circuit à retard ainsi que du potentiel au point de sortie, en ce que ledit circuit à retard a pour fonction d'entraîner que le quatrième transistor (TS2) soit bloqué afin que le fonctionnement du circuit de protection soit inhibé pendant ladite période prédéterminée, et en ce que ladite augmentation de l'impédance du premier transistor (T01) par ledit circuit de protection est suffisante pour bloquer le premier transistor.

2. Circuit d'attaque de sortie selon la revendication 1, dans lequel ledit circuit à retard consiste en un inverseur.

3. Circuit d'attaque de sortie selon la revendication 2, dans lequel ledit inverseur comporte un cinquième et un sixième transistor (TI1, TI2).

4. Circuit d'attaque de sortie selon la revendication 3, dans lequel le cinquième transistor (TI1) comporte un drain connecté à la ligne d'alimentation de potentiel supérieur (Vcc) et une grille et une source toutes deux connectées à la grille du quatrième transistor (TS2) et le sixième transistor (TI2) comporte un drain connecté à la source du cinquième transistor (TI1), une grille connectée audit dispositif d'application d'un premier et d'un second signau d'attaque mutuellement complémentaires (X, X̄) et une source connectée à la ligne d'alimentation de potentiel inférieur.

5. Circuit d'attaque de sortie selon la revendication 3 ou 4, dans lequel la grille du cinquième transistor (TI1) et la grille du troisième transistor (TS1) sont toutes deux connectées à la source du cinquième transistor (TI1) et au drain du sixième transistor (TI2).

6. Circuit d'attaque de sortie selon l'une quelconque des revendications précédentes, dans lequel le drain du troisième transistor (TS1) est connecté au drain du quatrième transistor (TS2)

7. Circuit d'attaque de sortie selon l'une quelconque des revendications précédentes, dans lequel la grille dudit troisième transistor (TS1) est connectée à la ligne d'alimentation de potentiel supérieur (Vcc) de manière à recevoir la tension de référence prédéterminée.

*Fig. 1*

*Fig. 2*

*Fig. 3*

# Fig. 4

# Fig. 6

# Fig. 8

# Fig. 5A

# Fig. 5B

# Fig. 5C

# Fig. 7A

# Fig. 7B

# Fig. 7C